Europäisches Patentamt

European Patent Office

Office européen des brevets

(19)

(11) Veröffentlichungsnummer: **0 004 382**
**A1**

(12) # EUROPÄISCHE PATENTANMELDUNG

(21) Anmeldenummer: **79100889.9**

(22) Anmeldetag: **23.03.79**

(51) Int. Cl.²: **G 01 R 19/16,** G 01 R 31/00,
H 01 M 10/48

(30) Priorität: **23.03.78 DE 2812874**

(43) Veröffentlichungstag der Anmeldung: **03.10.79**
**Patentblatt 79/20**

(84) Benannte Vertragsstaaten: **FR GB IT**

(71) Anmelder: **ACCUMULATORENFABRIK**
**SONNENSCHEIN GMBH, D-6470**
**Büdingen (Oberhessen) (DE)**

(72) Erfinder: **Eberts, Klaus, Dr. Dipl.-Phys.,**
**Grünwaldweg 4, D-6470 Büdingen 1 (DE)**

(74) Vertreter: **Hansmann, Axel, Dipl.-Wirtschafts-Ing. et al,**
**Licht, Schmidt, Hansmann, Hermann Patentanwälte**
**P.O. Box 701205 Albert-Rosshaupter-Strasse 65,**
**D-8000 München 70 (DE)**

(54) **Verfahren und Vorrichtung zum fortlaufenden Anzeigen der Qualität einer Batterie.**

(57) Es wird ein Verfahren und eine Vorrichtung zum fortlaufenden Anzeigen der Qualität einer Batterie angegeben.
Gemäß dem Verfahren wird die Batterie mit regelmässig
wiederkehrenden kurzen Entladestromimpulsen belastet,
der sich jeweils bei einem Entladestromimpuls einstellende
Batteriespannungswert wird meßtechnisch erfaßt sowie
bis zum Auftreten des nächsten Entladestromimpulses
gespeichert, und die Differenz zwischen dem Batteriespannungswert und einem vorgegebenen Minimalspannungswert wird als Maß für die Qualität der Batterie fortlaufend zur Anzeige gebracht. Die Vorrichtung hat Einrichtungen zum Belasten einer Batterie mit im zeitlichen
Abstand aufeinanderfolgenden Entladestromimpulsen
zum Erfassen der sich unter einem Entladestromimpuls
einstellenden Batteriespannungswerte, einen Speicher,
in dem der jeweils erfaßte Batteriespannungswert bis zum
Auftreten des nächsten Entladestromimpulses speicherbar
ist, und eine Anzeigeeinrichtung, durch welche die Differenz zwischen dem Batteriespannungswert und einem
vorgegebenen Minimalspannungswert angezeigt wird.

## Verfahren und Vorrichtung zum fortlaufenden Anzeigen der Qualität einer Batterie

Eine wiederaufladbare Batterie, beispielsweise ein Bleiakkumulator, besitzt bekanntlich nur eine begrenzte Lebensdauer, da die Kapazität mit zunehmender Betriebszeit geringer wird und schliesslich einen Wert erreicht, bei dem die Batterie ausgewechselt werden muss. Insbesondere eine zur Notstromversorgung eingesetzte Batterie muss am Ende ihrer Lebensdauer umgehend ausgewechselt werden, um die unter Umständen lebenswichtige Notstromversorgung sicherzustellen. Zur Überwachung der Funktionsfähigkeit einer zur Notstromversorgung eingesetzten Batterie ist es bereits bekannt, die Batterie von Zeit zu Zeit mit kurzen Entladestromimpulsen zu belasten, die sich unter diesen Entladestromimpulsen einstellende Batteriespannung mit einer vorgegebenen Mindestspannung zu vergleichen und ein Signal auszulösen, wenn der Unterschied zwischen diesen beiden Spannungen einen bestimmten Mindestwert unterschreitet oder gleich Null wird.

Zur möglichst frühzeitigen Einplanung eines Batteriewechsels wäre es für einen Anwender vorteilhaft, wenn er stets über die noch zu erwartende Lebensdauer einer Batterie, d.h. über ihre Qualität, Bescheid wüsste. Der Erfindung liegt daher die Aufgabe zugrunde, ein Verfahren und eine Vorrichtung zu schaffen, die eine fortlaufende Anzeige der Qualität einer Batterie liefern.

Gelöst wird diese Aufgabe einmal durch ein Verfahren zum fortlaufenden Anzeigen der Qualität einer Batterie, das erfindungsgemäss dadurch gekennzeichnet ist, dass die Batterie mit regelmässig wiederkehrenden kurzen Entladestromimpulsen belastet wird, der sich jeweils bei einem Entladestromimpuls einstellende Batteriespannungswert messtechnisch erfasst sowie bis zum Auftreten des nächsten
Entladestromimpulses gespeichert wird und die Differenz zwischen
dem Batteriespannungswert und einem vorgegebenen Minimalspannungswert als Maß für die Qualität der Batterie fortlaufend zur Anzeige gebracht wird.

Die Differenz zwischen dem sich unter einem Entladestromimpuls
einstellenden Batteriespannungswert nimmt nach Inbetriebnahme der
Batterie zunächst nur sehr langsam, mit zunehmender Betriebszeit
jedoch schneller ab, so dass bei der erfindungsgemäss erfolgenden
fortlaufenden Anzeige dieser Differenz eindeutige Rückschlüsse auf
die Qualität, d.h. auf die noch zu erwartende Lebensdauer der Batterie
möglich sind.

Gemäss einer Ausgestaltung der Erfindung wird weiterhin angezeigt,
ob die Batterie gerade geladen oder entladen wird. Die Ladungsanzeige
bzw. Entladungsanzeige signalisiert dem Anwender, dass die Qualitätsanzeige nicht eindeutig ist, da bei Belastung der Batterie mit einem
kurzen Stromentladeimpuls während einer gerade ablaufenden Entladung
oder Ladung sich ein anderer Batteriespannungswert und damit eine
andere Differenzspannung einstellt als dies bei Belastung der im Ruhezustand befindlichen Batterie der Fall ist.

Zur Ausschaltung einer verfälschten Qualitätsanzeige kann bei einer
im Bereitschaftsparallelbetrieb eingesetzten Batterie das zur Batterie
parallel geschaltete Netz- oder Ladegerät jeweils bei Belastung der
Batterie mit einem Entladestromimpuls abgeschaltet werden. In der gleichen Weise kann auch ein an die Batterie angeschlossener Verbraucher jeweils bei Belastung der Batterie mit einem Entladestromimpuls von der Batterie abgeschaltet oder auf das Netzgerät umgeschaltet werden.

Eine erfindungsgemässe Vorrichtung zum fortlaufenden Anzeigen der Qualität einer Batterie besteht aus einer Einrichtung zum Belasten der Batterie mit im zeitlichen Abstand aufeinanderfolgenden Entladestromimpulsen, einer Einrichtung zum Erfassen des sich jeweils unter einem Entladestromimpuls einstellenden Batteriespannungswertes, einem Speicher zum Speichern des jeweils erfassten Batteriespannungswertes bis zum Auftreten des nächsten Entladestromimpulses und einer Anzeigeeinrichtung, durch welche die Differenz zwischen dem jeweils erfassten Batteriespannungswert und einem vorgegebenen Minimalspannungswert als Maß für die Qualität der Batterie fortlaufend angezeigt werden kann.

Als Anzeigeeinrichtung eignet sich insbesondere ein anzeigender Spannungsmesser mit Nullpunktunterdrückungsmöglichkeit, der mit dem im Speicher gespeicherten Batteriespannungswert beaufschlagt wird und bei dem als Nullpunkt der vorgegebene Minimalspannungswert eingestellt wird. Ein derartiger Spannungsmesser wirkt also gleichzeitig als Differenz- und Anzeigeglied.

Als Anzeigeeinrichtung können vorzugsweise auch eine Reihe von Anzeigeelementen, insbesondere Anzeigelämpchen oder Leuchtdioden, vorgesehen werden, deren Ansprechschwellwerte derart abgestuft sind, dass jeweils eine der Differenz zwischen dem erfassten Batteriespannungswert und dem vorgegebenen Minimalspannungswert entsprechende Anzahl von Anzeigeelementen zum Ansprechen gebracht

wird. Leuchten beispielsweise von zehn vorhandenen Anzeigeelementen fünf auf, zeigt dies an, dass die Batterie lediglich noch eine Qualität von 50 % besitzt. Dabei ist vorausgesetzt, dass bei Inbetriebnahme der Batterie die Anzeigeeinrichtung derart einjustiert worden ist, dass die Anzeigeelemente eine Qualität von 100 % angezeigt haben, d.h. sämtliche zehn Anzeigeelemente aufgeleuchtet haben.

Die Anzeigeeinrichtung ist zweckmässigerweise auch mit zusätzlichen Anzeigeorganen in Form von Anzeigelämpchen oder Leuchtdioden ausgestattet, die zur Anzeige eines Lade- und Entladevorganges der Batterie vorgesehen sind.

Es ist zweckmässig, den von der Anzeigeeinrichtung als Maß für die Qualität der Batterie angezeigten Wert als Prozentangabe kenntlich zu machen. Bei Verwendung eines anzeigenden Spannungsmessers mit Nullpunktunterdrückung als Anzeigeeinrichtung wird die Anzeigeskala als Prozentskala ausgelegt und dafür gesorgt, dass bei Inbetriebnahme der Batterie eine Qualität von 100 % angezeigt wird, während dem für die Batterie vorgegebenen Minimalspannungswert eine Anzeige von 0 % zugeordnet wird.

Zum Erfassen und Speichern der Batteriespannung sowie zum Anzeigen der Differenzspannung können neben analog arbeitenden Einrichtungen auch digital arbeitende Einrichtungen verwendet werden. Es ist auch möglich, im Speicher bereits die Differenz des jeweils erfassten Batteriespannungswertes und des vorgegebenen Minimalspannungswertes zu speichern. In diesem Fall wird vom erfassten Batteriespannungswert der vorgegebene Minimalspannungswert vor dem Einspeichern in den Speicher abgezogen oder der Speicher derart ausgestaltet, dass er automatisch die Differenz zwischen dem erfassten Batteriespannungswert und dem vorgegebenen Minimalspannungswert speichert.

0004382

Accumulatorenfabrik
Sonnenschein GmbH

6470 Büdingen (Oberhessen)

23. März 1979   He/Lü

PATENTANSPRÜCHE

1.   Verfahren zum fortlaufenden Anzeigen der Qualität einer Batterie, dadurch gekennzeichnet, dass die Batterie mit regelmässig wiederkehrenden kurzen Entladestromimpulsen belastet wird, der sich jeweils bei einem Entladestromimpuls einstellende Batteriespannungswert messtechnisch erfasst sowie bis zum Auftreten des nächsten Entladestromimpulses gespeichert wird und die Differenz zwischen dem Batteriespannungswert und einem vorgegebenen Minimalspannungswert als Maß für die Qualität der Batterie fortlaufend zur Anzeige gebracht wird.

2.   Verfahren nach Anspruch 1, dadurch gekennzeichnet, dass weiterhin zur Anzeige gebracht wird, ob die Batterie gerade geladen oder entladen wird.

3.   Verfahren nach Anspruch 1, dadurch gekennzeichnet, dass bei einer im Bereitschaftsparallelbetrieb eingesetzten Batterie das zur Batterie parallel geschaltete Netz- oder Ladegerät jeweils bei Belastung der Batterie mit einem Entladestromimpuls abgeschaltet wird.

0004382

4. Verfahren nach Anspruch 1 oder 3, dadurch gekennzeichnet, dass ein an die Batterie angeschlossener Verbraucher jeweils bei Belastung der Batterie mit einem Entladestromimpuls von der Batterie abgeschaltet oder auf das Netzgerät umgeschaltet wird.

5. Vorrichtung zur Durchführung des Verfahrens nach einem der Ansprüche 1-4, gekennzeichnet durch eine Einrichtung zum Belasten einer Batterie mit im zeitlichen Abstand aufeinanderfolgenden Entladestromimpulsen, eine Einrichtung zum Erfassen der sich unter einem Entladestromimpuls einstellenden Batteriespannungswerte, einen Speicher, in dem der jeweils erfasste Batteriespannungswert bis zum Auftreten des nächsten Entladestromimpulses speicherbar ist, und eine Anzeigeeinrichtung, durch welche die Differenz zwischen dem Batteriespannungswert und einem vorgegebenen Minimalspannungswert als Maß für die Qualität der Batterie fortlaufend angezeigt wird.

6. Vorrichtung nach Anspruch 5, dadurch gekennzeichnet, dass als Anzeigeeinrichtung ein anzeigender Spannungsmesser mit Nullpunktunterdrückungsmöglichkeit vorgesehen ist, der mit dem im Speicher gespeicherten Batteriespannungswert beaufschlagt wird und bei dem als Nullpunkt der vorgegebene Minimalspannungswert eingestellt ist.

7. Vorrichtung nach Anspruch 5, dadurch gekennzeichnet, dass die Anzeigeeinrichtung eine Reihe von Anzeigeelementen, insbesondere Anzeigelämpchen oder Leuchtdioden, umfasst, deren Ansprechschwellwerte derart abgestuft sind, dass jeweils eine der Differenz zwischen dem erfassten Batteriespannungswert und dem vorgegebenen Minimalspannungswert entsprechende Anzahl von Anzeigeelementen zum Ansprechen gebracht wird.

0004382

8. Vorrichtung nach Anspruch 5 oder 6, dadurch gekennzeichnet, dass für die Anzeigeeinrichtung zusätzliche Anzeigeorgane zur Anzeige eines Lade- und Entladevorganges der Batterie vorgesehen sind.

9. Vorrichtung nach Anspruch 5 oder 6, dadurch gekennzeichnet, dass der von der Anzeigeeinrichtung als Maß für die Qualität der Batterie angezeigte Wert als Prozentangabe kenntlich gemacht ist.

| Kategorie | EINSCHLÄGIGE DOKUMENTE Kennzeichnung des Dokuments mit Angabe, soweit erforderlich, der maßgeblichen Teile | betrifft Anspruch | KLASSIFIKATION DER ANMELDUNG (Int.Cl.²) |
|---|---|---|---|
| | DE - B - 2 610 536 (SIEMENS) <br> * Spalte 1, Zeile 56 bis Spalte 3, Zeile 11; Spalte 4, Zeile 11 bis Spalte 5, Zeile 5; Fig. 3 * <br> -- | 1, 5 | G 01 R 19/16 <br> G 01 R 31/00 <br> H 01 M 10/48 |
| | DE - B - 2 043 660 (BOSCH) <br> * Anspruch 1, Spalte 2, Zeile 54 bis Spalte 4, Zeile 27; Fig. 1 * <br> -- | 1, 5 | |
| | US - A - 4 020 414 (PAREDES) <br> * Spalte 1, Zeile 42 bis Spalte 2, Zeile 49; Fig. 1 * <br> -- | 7,8 | RECHERCHIERTE SACHGEBIETE (Int. Cl.²) <br><br> G 01 R 19/16 <br> G 01 R 31/00 <br> H 01 M 10/48 <br> H 02 J 7/00 |
| A | DE - A - 2 630 033 (STILL) <br> * ganzes Dokument * <br> ---- | | |

KATEGORIE DER GENANNTEN DOKUMENTE

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 18-06-1979 | LEMMERICH |

EPA form 1503.1 06.78